# EUROPEAN PATENT SPECIFICATION

(11) **EP 1 786 250 B1**
(45) Date of publication and mention of the grant of the patent: **19.10.2011**
(21) Application number: 06255825.9
(22) Date of filing: 14.11.2006
(51) Int. Cl.: H05K 3/46, H05K 3/40

(54) **Composite wiring board and manufacturing method thereof**
Verbundleiterplatte und Herstellungsverfahren derselben
Carte de câblage composite et son procédé de fabrication

(30) Priority: 14.11.2005 JP 2005329337; 24.01.2006 JP 2006015652
(43) Date of publication of application: 16.05.2007
(73) Proprietor: TDK Corporation, Tokyo 103-8272 (JP)
(72) Inventor: Kobuke, Hisashi c/o TDK Corporation, Tokyo 103-8272 (JP); Miyakoshi, Toshinobu c/o TDK Corporation, Tokyo 103-8272 (JP); Uematsu, Hiroyuki c/o TDK Corporation, Tokyo 103-8272 (JP)
(74) Representative: Feakins, Graham Allan

(56) References cited:
- EP-A2- 0 332 559
- EP-A2- 0 535 711
- JP-A- 10 075 060
- US-A- 5 219 639
- US-A1- 2005 151 303
- US-A1- 2006 081 977
- US-B1- 6 353 189

## Description

The present invention relates to a composite wiring board comprising a ceramic substrate and a resin layer in contact with at least one surface of the ceramic substrate and to a manufacturing method thereof.

In the fields of electronic equipment etc., ceramic substrates for mounting an electronic device thereon have widely been used. In recent years, multilayer ceramic substrates have been proposed as a highly reliable ceramic substrate satisfying the demands for making electronic equipment small-sized, lightweight and multifunctional and put to practical use. A ceramic substrate comprises a plurality of ceramic layers laminated and has a wiring conductor, an electron device, etc. incorporated integrally into each ceramic layer to form a circuit board of high density.

On the other hand, increasing demands for making electronic equipment further highly functional and highly precise have been accompanied by attention focused on a composite wiring board comprising a ceramic wiring board and a resin layer in combination. The composite wiring board is expected to have an improvement in its surface flatness to a great extent owing to the resin layer provided thereon. As a result of the improvement in surface flatness, a further refined wiring is materialised and furthermore good mountability of chip parts, such as semiconductors, is attained. These are advantageous.

In the composite wiring board, for the purpose of connecting a wiring pattern on the surface of the resin layer that is the outermost layer electrically to an internal layer pattern or radiating heat from the ceramic substrate, the resin layer is possibly provided with a "via" - a route or a medium by or through which something can be transmitted or conveyed. Examples of the "via" providing method include a method of filling a "via-hole" with conductive resin and a method utilising plating, as proposed in JP-A 2003-124435 and JP-A 2004-253512. Also proposed in JP-A 2003-188538 is a method comprising the steps of forming a via hole in a resin prepreg sheet, filling the via hole with conductive paste, attaching under pressure the resultant sheet and a multilayer ceramic substrate as overlapping each other and curing the entirety.

While it is conceivable that making a wiring board and a resin layer composite proves to be effective as one means for replying to the demand for a wiring board multifunctional and small-sized, the work of piercing a via conductor etc. through the resin layer is difficult to perform, resulting in posing various problems. The methods described in JP-A 2003-124435 and JP-A 2004-253512, for example, adopt the steps of forming a resin layer over the entire surface of a ceramic substrate, then forming a through hole (via hole) and thereafter conducting filling or plating with conductive resin. Thus, there are several steps. In addition, since the resin layer covers the entire surface of the ceramic substrate, high-precision alignment is required for forming the through hole precisely.

The invention described in JP-A 2003-188538 has an advantage in that both a resin layer and a "via" or "transmittal medium or means" are simultaneously formed. However, since the resin layer covers the entire surface of the ceramic substrate, it is impossible to visually confirm the state of connection between the via and a surface conductor or an internal conductor of the ceramic substrate. As a consequence, very high-precision alignment is required to possibly bring about a cumbersome manufacturing process.

In ceramic substrates including a multilayer ceramic substrate, degradation in dimensional accuracy and flatness resulting from the shrinkage occurring during the course of firing is greatly problematic. A multilayer ceramic substrate is produced from a laminate into which plural green sheets are laminated and which is fired. While green sheets are shrunk as accompanied by being sintered in the firing process, the degree of shrinkage and shrinking direction vary depending on the substrate materials, green sheet compositions, production lots and production conditions. The variation in shrinkage of the green sheets greatly lowers the dimensional accuracy and flatness of the multilayer ceramic substrate. In the multilayer ceramic substrate finally obtained, the dimensional accuracy, for example, sticks around 0.5%.

The variation in shrinkage induces various defects as described hereinafter. To be specific, though screen-printing plates for printing of internal electrodes, for example, have to be fabricated after the degree of shrinkage of a substrate is calculated back, a change in degree of shrinkage of the substrate requires the screen-printing plate to be re-fabricated a number of times. This is uneconomical. In addition, an electrode of an unduly large area has to be formed so as to allow shrinkage errors in advance. This prevents wirings from being made highly dense. Furthermore, in case where a substrate material and a dielectric material are simultaneously fired for the purpose of incorporating a high-capacity condenser into a multilayer ceramic substrate, when the substrate and dielectric materials differ in degree of shrinkage in the plane direction, the portion of the substrate surface where the dielectric has been formed induces dents to deteriorate the part mountability. Moreover, since the degrees of shrinkage of green sheets between the width direction and the longitudinal direction differ depending on the film formation direction, this is also problematic from the manufacturing point of view.

The thus induced degradation in dimensional accuracy and flatness of the ceramic substrate invariably degrades the dimensional accuracy and flatness of a composite wiring board to be obtained. It is therefore required to take steps to improve this point.

Reference should also be made to EP-A-0332 559, which discloses means to provide sealing and stress relief for a glass-ceramic substrate.

The present invention has been proposed in view of the conventional state of affairs. An object of the present invention is to provide a composite wiring board comprising a ceramic substrate and a resin layer in combination and a manufacturing method thereof enabling a manufacturing process to be simplified and the dimensional accuracy and flatness thereof to be enhanced.

To attain the above object, the present invention provides as the first aspect thereof a method for manufacturing a composite wiring board, comprising the steps of:
forming a through hole in a sheet having a shrinkage-suppressing effect and filling the through hole with conductive paste to obtain a sheet for formation of a conductor;
firing the sheet for formation of the conductor and a green sheet for a substrate in their laminated state to obtain a ceramic substrate having a surface provided with a sintered metal conductor;
removing from the surface of the ceramic substrate a fired product of the sheet having the shrinkage-suppressing effect; and
forming a resin layer on the surface of the ceramic substrate, characterised in that the step of firing is performed in a state wherein the sheet for formation of the conductor is further laminated with a sheet having a shrinkage-suppressing effect.

The sheet having the shrinkage-suppressing effect may be a green sheet for shrinkage suppression.

The green sheet for shrinkage suppression may contain a sintering aid and at least one member selected from the group consisting of quartz, cristobalite and tridymite and that the sintering aid is at least one species selected from the group consisting of oxides softened or forming a liquid phase at a temperature equal to or less than a sintering starting temperature of the green sheet for the substrate and alkali metal compounds.

The green sheet for shrinkage suppression may contain tridymite sintered in the step of firing and an oxide not sintered in the step of firing.

The sheet having the shrinkage-suppressing effect may be a sheet containing calcium carbonate.

The sheet having a shrinkage-suppressing effect may be a sheet containing zirconium oxide or aluminium oxide.

The method may further comprise the step of laminate printing conductive paste on a surface of the sheet having the shrinkage-suppressing effect.

The method may further comprise the steps of forming a concavity in the sheet having the shrinkage-suppressing effect, filling the concavity with conductive paste and laminating the sheet for formation of the conductor and the green sheet for the substrate so that the conductive paste in the concavity is in contact with the green sheet for the substrate.

The green sheet for the substrate may comprise a plurality of green sheets laminated into a laminate and wherein the sheet for formation of the conductor is disposed on at least one surface of the laminate.

The step of forming the resin layer may comprise disposing a resin sheet on the surface of the ceramic substrate and laminating it thereon by means of vacuum lamination.

The vacuum lamination may comprise disposing the ceramic substrate and resin sheet between a heating flat plate and a film, depressurising spacing defined by the heating flat plate and film and using heated air to swell the film and urge the ceramic substrate and resin sheet toward the heating flat plate, thereby completing the lamination.

The curing of the resin sheet laminated on the ceramic substrate may be by using a heating atmosphere as a medium. The curing step of the resin sheet may comprise pressure application using the heating atmosphere as the medium.

The resin sheet may be a resin material formed on a support and brought to a semi-hardened state.

Preferably, when the ceramic substrate has an area s (mm²) and a thickness of t (mm), s/t is in a range of 10,000 to 250,000.

The method may further comprise the step of grinding a surface of the resin layer formed on the surface of the ceramic structure.

Since the sheet having the effect of shrinkage suppression is utilised as a sheet for forming a sintered metal conductor, the shrinkage of the green sheet for a substrate otherwise occurring in the plane direction is suppressed. As a result, the dimensional accuracy in the in-plane direction and flatness of a ceramic substrate to be obtained become good and those of a composite wiring board using the ceramic substrate also become good. When a green sheet for shrinkage suppression is used as the sheet having the effect of shrinkage suppression, in particular, the effect of improving the dimensional accuracy and flatness can be conspicuously manifested.

In JP-A HEI 6-53655, for example, the procedure adopted comprises the steps of forming holes in a non-sintered sheet, filling the holes with conductors for formation of bumps, laminating the resultant sheet on a green sheet and heating the laminate. The attention of this prior art reference is focussed only on the formation of the bumps on the ceramic substrate. No description is found therein concerning the step of making a ceramic substrate and a resin layer composite and the step of piercing a conductor and using it as a via such as a transmittal medium, for example.

JP-A 2005-197663 describes a method comprising the steps of fabricating a ceramic substrate, laminating on the ceramic sheet a non-sintered sheet having a thick-film member filled therein and heating the laminate to form convexes including a conductor, an insulator, etc. on the ceramic substrate. This method requires firing to be effected twice (that for fabrication of the ceramic substrate and that for formation of the convexes), thus increasing the number of the steps.

According to the present invention, it is intended to enhance the dimensional accuracy and flatness of a ceramic substrate, while simplifying the manufacturing process of a composite wiring board, to enhance part mountability and to make a composite wiring board further highly dense, i.e. more compact.

For a better understanding of the invention and to show how the same may be carried into effect, reference will now be made, by way of example, to accompanying drawings, in which:-
Figure 1 is a schematic cross section showing a composite wiring board.
Figure 2 is an explanatory view showing one example of the manufacturing method of the composite wiring board shown in Figure 1, with green sheets for a ceramic substrate shown schematically in cross section,
Figure 3 is an explanatory view showing another example of the manufacturing method of the composite wiring board shown in Figure 1, with one example of the conductor-forming sheet shown schematically in cross section,
Figure 4 is a schematic cross section showing another example of the conductor-forming sheet,
Figure 5 is an explanatory view showing another example of the manufacturing method of the composite wiring board shown in Figure 1, with the conductor-forming sheets and green sheets for a ceramic substrate being laminated with each other,
Figure 6 is a schematic view showing one example of the manufacturing method of the composite wiring board, with the ceramic substrate schematically shown in cross section before the formation of resin layers thereon,
Figure 7 is an explanatory view showing one example of the manufacturing method of the composite wiring board by a laminating process using vacuum lamination schematically shown in cross section,
Figure 8 is an explanatory view showing one example of the manufacturing method of the composite wiring board by a resin-curing process using a heat and pressure application apparatus schematically shown in cross section,
Figure 9 is a schematic cross section showing another example of a composite wiring board.
Figure 10 is a schematic cross section showing one example of the conductor-forming sheet for the manufacture of the composite wiring board shown in Figure 9,
Figure 11 is a schematic cross section showing another example of the conductor-forming sheet for the manufacture of the composite wiring board shown in Figure 9,
Figure 12 is a schematic cross section showing another example of the manufacturing method of the composite wiring board shown in Figure 1, and
Figure 13 is a schematic cross section showing the manufacturing method according to the invention of the composite wiring board shown in Figure 1.

In this specification, the term "via", when used as a noun, is intended to convey the general concept of a means or medium that provides or enables a route between parts for the transmittal, conduction or conveyance of matter in general, e.g. electricity and heat, or some intermediate material for the purpose described, as can be interpreted by the particular application described herein.

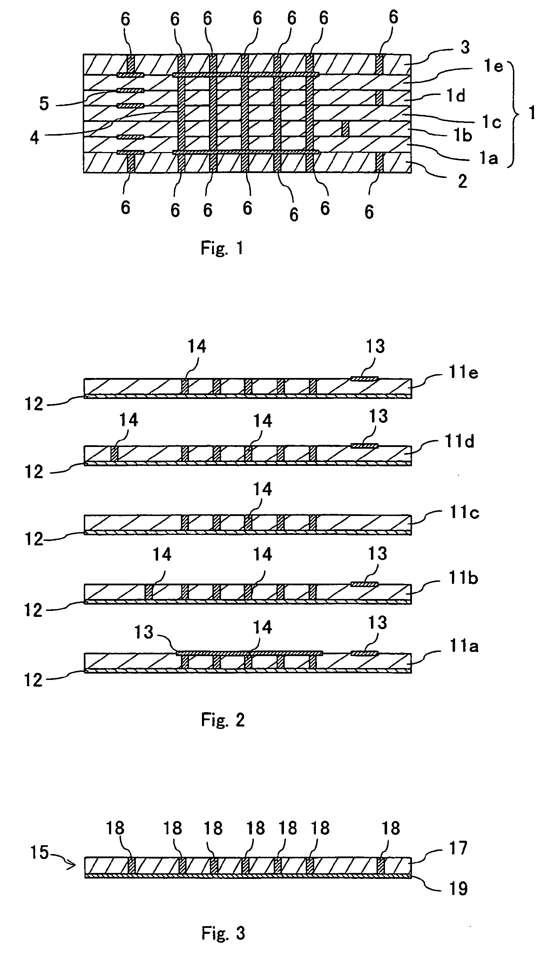

A composite wiring board is advantageously used as a high-frequency part. The composite wiring board shown in Figure 1 comprises a ceramic substrate 1 and resin layers 2 and 3 disposed in contact with the opposite surfaces of the ceramic substrate 1.

The ceramic substrate 1 is preferably a Low Temperature Co-fired Ceramic (LTCC) substrate formed of a glass ceramic fireable at low temperatures of 1000°C or less, for example. The ceramic substrate 1 is a multilayer ceramic substrate which have a plurality of ceramic layers 1a to 1e laminated and integrated and into which internal patterns 5 including a wiring patterns formed on the surfaces of the ceramic layers, electrode pattern, etc. and internal conductors including vias 4 piercing through the internal patterns 5 etc. for interlayer connection or heat radiation are incorporated. Electronic devices, such as an inductor, capacitor, etc., (not shown) may be incorporated into the ceramic substrate 1. As a ceramic material constituting the ceramic substrate 1, any of ceramic materials generally used for ceramic substrates of this kind is usable.

The internal conductors of the ceramic substrate 1 are formed of sintered metal, for example. As materials for the internal conductors, though not particularly limited, metals, such as Ag, Pd, Au, Cu, Ni, etc. can be used, for example.

The resin layers 2 and 3 are formed of resin material. Any resin materials that can be moulded into a sheet, film, etc. is usable. As the resin materials, for example, both thermoplastic resins and thermosetting resins are usable, and concrete examples thereof include epoxy resins, phenol resins, vinylbenzylether compound resins, bismaleimidtriazine resins, cyanateester-based resins, polyimide, polyolefin-based resins, polyester, polyphenylene oxides, liquid crystal polymers, silicone resins, fluorine-based resins. These resins may be used singly or in combination. Furthermore, resin materials may be rubber materials, such as acryl rubber, ethylene acryl rubber, etc., resin materials partially containing a rubber component, or resin materials containing inorganic filler, such as ceramics, etc.

The resin layers 2 and 3 are provided with sintered metal conductors 6 formed of sintered metal and piercing through the resin layers 2 and 3. As the material for the sintered metal conductors 6, any of metals assuming a sintered state and used for substrates of this kind can be used and may be the same as that for the internal conductors, i.e. Ag, Pd, Au, Cu, Ni or alloys thereof, for example. Among other metals enumerated above, Ag proves favourable. The sintered metal conductor 6 contains 90% or more of any of the aforementioned metals and an oxide. It may further contain a glass component. Examples of the glass component includes those containing as a main component at least one oxide selected from the group consisting of PbO, SiO₂, B₂O₃, ZnO and alkali rare earth metal oxides. It is noted, however, the sintered metal conductor 6 may not always contain an oxide or a glass component.

The sintered metal conductor 6 is formed into a columnar shape, for example, and may be given a function as a via for an interlayer connection between wirings on the surfaces of the resin layers 2 and 3 and the internal conductor of the ceramic substrate 1, a via for heat radiation, a mark for alignment when forming conductors (not shown) on the surfaces of the resin layers 2 and 3, for example, etc. The sintered metal conductor 6 may have a single function as an interlayer connection via, heat radiation via or alignment mark, or may have functions together as the interlayer connection via and the alignment mark.

In the composite wiring board, the ceramic wiring substrate is provided on the surface thereof with the resin layer to make it possible to reduce undulation or asperity of the surface of the ceramic substrate, thereby improving the surface flatness to a great extent as compared with that of a conventional ceramic substrate. For example, an ordinary ceramic substrate has an undulating surface ranging from 20 µm to 50 µm. The provision of the resin layer on the ceramic substrate surface substantially eliminates the surface undulation. Though polishing the substrate surface can flatten the undulation, it is advantageous that the resin layer surface is easy to polish as compared with the ceramic substrate surface.

Since the formation of the resin layer improves the surface flatness, Cu that can be subjected to photolithographic processing, for example, can be used as a surface conductor on the surface of the resin layer, thereby enabling further refinement of a wiring (surface conductor). The enhancement in the surface flatness can realise a high photolithographic resolution, it contributes to further refinement of the wiring. For example, a narrow wiring pitch of 10 µm to 80 µm difficult to materialise due to the presence of the undulation on the ceramic substrate is made possible, thereby further highly densifying a circuit board. Moreover, it is advantageous that the improvement in the surface flatness makes the mountability of chip parts, such as semiconductors, superior.

One example of the manufacturing method of the composite wiring board shown in Figure 1 will be described hereinafter. A significant characteristic feature of the present invention lies in fabricating the ceramic substrate 1 making use of a so-called non-shrinkage firing process capable of suppressing the shrinkage in the in-plane direction and shrinking only in the thickness direction of the green sheets for the substrate and simultaneously forming conductors, such as vias, piercing through the resin layers 2 and 3.

To fabricate the ceramic substrate 1 of multilayer structure, green sheets 11a to 11e for a substrate constituting the ceramic layers 1a to 1e are prepared as shown in Figure 2. The green sheets 11a to 11e are formed mixing ceramic powder and an organic vehicle to obtain slurry dielectric paste and using the doctor blade method to form on a support 12 like a PolyEthylene Terephthalate (PET) sheet, for example, the paste in the form of a film. Any of the known ceramic powders and known organic vehicles is usable for this purpose.

When, as the ceramic substrate 1, a glass ceramic substrate firable at low temperatures is fabricated, ceramic powder and glass powder are used together for the fabrication of a dielectric paste. The glass component and ceramic component thereof may be selected suitably on the basis of the relative permittivity and firing temperature aimed at.

The green sheets 11a to 11e for a substrate may, as occasion demands, have internal conductors, such as internal layer patterns 5, vias 4 for interlayer connection of the internal layer patterns, etc., and electronic devices, such as an inductor, capacitor, etc. (not shown), incorporated thereinto. The vias 4 are formed by the procedure of forming through holes in the green sheets 11a to 11e at predetermined positions and filling the through holes with conductive paste 14. The internal layer patterns 5 are formed, by the screen-printing of conductive paste 13, into the predetermined shapes on the surface of the green sheet 11 for a substrate opposite the surface thereof on which the support 12 is provided.

The conductive paste is prepared through kneading of a conductive material comprising a conductive metal, such as Ag, Pd, Au, Cu, Ni, etc., or alloy thereof, with an organic vehicle. The organic vehicle is composed preponderantly of a binder and a solvent. While the mixing ratio of the organic vehicle to the conductive material is arbitrary, mixing is performed so that 1 to 15 mass % of a binder and 10 to 50 mass % of a solvent may generally be mixed with the conductive material. The conductive paste may be added, as occasion demands, with additives selected from various kinds of dispersants and plasticisers.

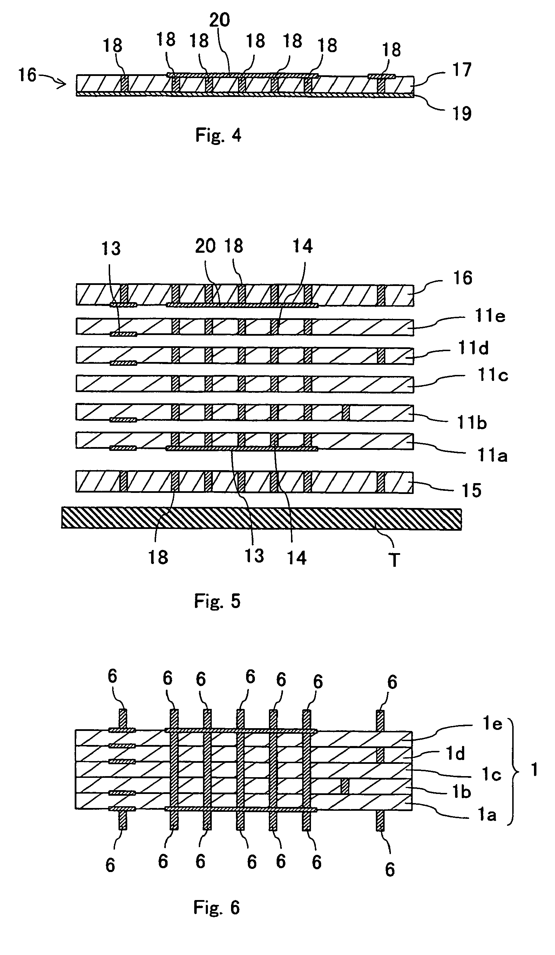

On the other hand, the sheet having a shrinkage-suppressing effect is formed with through holes in which conductive paste is filled to prepare a sheet for formation of a conductor. The conductor formation sheet is used for the purpose of suppressing the shrinkage of the ceramic substrate 1 in the in-plane direction and forming a sintered metal conductor 6 on the surface of the ceramic substrate 1. As the sheet having the shrinkage-suppressing effect, any sheet can be used insofar as it can suppress shrinkage in the plane direction of the ceramic substrate when being fired in a state of being laminated with the green sheets for a substrate. Specifically, a sheet for shrinkage suppression that is a green sheet not shrunk at a firing temperature, a sheet containing calcium carbonate (CaCO₃), a sheet containing zirconium oxide (zirconia) or aluminium oxide (alumina), etc. can be used. Sheets 15 and 16 for formation of a conductor are shown in FIG. 3 and FIG. 4. An example will be described, in which a green sheet for shrinkage suppression is used as a sheet 17 having the shrinkage-suppressing effect and constituting the sheets 15 and 16 for formation of a conductor. The sheet 17 having the shrinkage-suppressing effect is provided at positions thereof corresponding to those of the sintered metal conductors 6 in the resin sheet 2 with through holes in which conductive paste 18 is filled, thereby configuring the sheet for formation of a conductor.

As the green sheet for shrinkage suppression, a sheet containing a sintering aid and at least one member selected from the group consisting of quartz, cristobalite and tridymite can be used. The presence of the sintering aid in the given green sheet for shrinkage suppression enables green sheets for shrinkage suppression laminated on the opposite surfaces of the given green sheet to be sintered in the form of a sheet and the sintered products of the green sheets for shrinkage suppression to exfoliate in the form of a sheet from the surface of the ceramic substrate. Thus, the sintered products become easy to detach. When the green sheet for shrinkage suppression contains no sintering aid, it is not sintered in the firing step and exists on the substrate surface in the form of fine particles. Where the green sheet for shrinkage suppression is in the form of fine particles, since the grains are movable during the course of cooling, stress even when being exerted between the green sheet and the ceramic substrate at the phase transformation point may possibly be alleviated. On the other hand, when the green sheet for shrinkage suppression containing a sintering aid is used, the problems mentioned above can be eliminated, with the result that the removal of the sintered product can be attained more easily.

The sintering aid is at least one member selected from the group consisting of oxides softened or allowed to produce a liquid phase at a sintering initiating temperature or less of the green sheets for a substrate and alkali metal compounds. When using an oxide softened at a sintering initiating temperature or less of the green sheets for a substrate, the oxide softened bonds the grains of the composition together to attain sintering. In the case of using an oxide allowed to produce a liquid phase at a sintering initiating temperature or less of the green sheets for a substrate, the liquid phase allows the surfaces of the grains of the composition to react to thereby bond the grains together and consequently complete sintering. Though these oxides are not particularly limited, at least one oxide selected from the group consisting of lead silicate aluminium glass, lead silicate alkali glass, lead silicate alkaline earth glass, lead borosilicate glass, borosilicate alkali glass, aluminium borate lead glass, lead borate alkali glass, lead borate alkaline earth glass and lead borate zinc glass is preferred.

The alkali metal compounds have an effect of promoting the progress of sintering SiO₂. Therefore, a composition containing at least one member selected from the group consisting of quartz, cristobalite and tridymite is sintered by the addition of an alkali metal compound as a sintering aid. As the alkali metal compounds, though not particularly limited, lithium carbonate, potassium carbonate, sodium carbonate, lithium oxide and potassium oxide are preferred.

Otherwise, as the sheet for shrinkage suppression, a sheet containng tridymite sintered by firing for obtaining a ceramic substrate and an oxide not sintered by the firing can be used.

The tridymite sintered during the course of firing the green sheets for a substrate can be fabricated through addition of an alkali metal compound to quartz and heat treatment of the mixture obtained.

As the oxides not sintered during the course of firing the green sheets for a substrate, though not particularly limited, quartz, molten quartz, alumina, mullite, zirconia, etc. are advantageously used.

The firing temperature can variously be changed by the selection of the composition of tridymite. In addition, tridymite having been sintered induces a stress at the boundary with the substrate, provided that tridymite has a large thermal expansion coefficient that possibly reaches 40 ppm/°C depending on the firing temperature. For this reason, the green sheets for shrinkage suppression containing tridymyte possibly exfoliate before being sintered due to a large difference in thermal expansion between themselves and the glass ceramic material (thermal expansion coefficient: about 3 to 10 ppm/°C). To prevent this problem from being posed, an oxide not sintered at the firing temperature of the material for a ceramic substrate is added to adjust the thermal expansion coefficient and consequently allow the sintered material to exfoliate spontaneously in the form of a sheet. As a result, the removal of the fired product of the green sheet for shrinkage suppression from the ceramic substrate becomes ready without necessitating ultrasonic cleaning etc. Incidentally, in the sintering aspect in this case, it is conceivable that the same phenomenon as in the case of the sintering aid added to at least one member selected from the group consisting of quartz, cristobalite and tridymite occurs.

To fabricate each of the sheets 15 and 16 for a conductor, the sheet 17 having a shrinkage-suppressing effect is prepared. The sheet 17 having a shrinkage-suppressing effect is obtained by the steps of mixing the composition containing a sintering aid and at least one member selected from the group consisting of quartz, cristobalite and tridymite or the composition containing tridymite sintered during the course of firing for obtaining a ceramic substrate and an oxide not sintered by the firing with an organic vehicle to fabricate slurry paste and using the doctor blade method to form the paste on the support 19, such as a PET sheet, into a film sheet.

Through holes of a shape corresponding to that of the sintered metal conductors 6 are then formed in the sheet 17 having a shrinkage-suppressing effect. As the processing methods for the formation of the through holes, though not particularly limited, press working by means of moulds, punching processing or laser processing can be cited, for example.

The through holes are then filled with conductive paste 18. As the method of filling the conductive paste, though not particularly limited, a printing process, such as a screen process printing, can be raised. The conductive paste may be the same as that used for the formation of the internal layer patterns 5 of the ceramic substrate 1. By filling the conductive paste 18 in the through holes, the sheet 15 for formation of a conductor shown in Figure 3 can be obtained. Furthermore, by printing the conductive paste in a predetermined pattern on the surface of the sheet to be printed, the sheet 16 for formation of a conductor shown in Figure 4 can be obtained. The conductive pattern 20 printed on the surface of the sheet 16 for formation of a conductor constitutes the surfacemost conductor of the ceramic layer 1e.

Next, as shown in Figure 5, the sheet 15 for formation of a conductor, green sheets 11a to 11e for a substrate and sheet 16 for formation of a conductor thus obtained are laminated sequentially on a flat table T to overlap the sheets for formation of a conductor and green sheets for a substrate. At this time, the green sheets 11a to 11e and sheets 15 and 16 for formation of a conductor having exfoliated from the supports are laminated, with their respective printed surfaces directed downward. The laminate thus obtained may be subjected to pressing.

The laminate of the sheet 15 for formation of a conductor, green sheets 11a to 11e for a substrate and sheet 16 for formation of a conductor is then fired. As the firing atmosphere, an oxidised atmosphere, a reduced atmosphere, etc. can be used. To be specific, the atmospheric air may be used. The action of the sheets 17 having a shrinkage-suppressing effect and constituting the sheets 15 and 16 for formation of a conductor suppresses the shrinkage of the green sheets 11 in their in-plane direction and permits the shrinkage thereof in their thickness direction at the time of firing, with the result that the degree of shrinkage in the ceramic substrate 1 to be obtained that is ±1% or less, for example, can be realised. The dimensional accuracy at this time is 0.1% or less. This is very superior. By further optimising the degree of shrinkage, further superior dimensional accuracy of 0.05% or less can be secured.

Furthermore, the firing step allows the conductive paste 18 retained in the sheets 15 and 16 for formation of a conductor to adhere to the surface of the ceramic substrate 1 and the sintering reaction of the metals in the conductive paste 18 to proceed. After the firing step, since the sintered product of the sheets 17 having a shrinkage-suppressing effect assumes a state easy to exfoliate due to the difference in linear expansion coefficient from the ceramic substrate 1 etc. or a state of a sheet having exfoliated from the ceramic substrate, it is removed. Consequently, the conductive paste 18 (sintered metal conductors 6) filled in the sheets 15 and 16 for formation of a conductor and the conductive pattern 20 on the surface 16 for formation of a conductor are transferred onto the ceramic substrate 1 to obtain the ceramic substrate 1 provided on the surface thereof with the sintered metal conductors 6 as shown in Figure 6.

The resin layers 2 and 3 are formed on the surfaces of the ceramic substrate 1 shown in Figure 6 to obtain the composite wiring board shown in Figure 1. As a method of making the ceramic substrate 1 and the resin layers 2 and 3 composite, a pressing method conceivable, but possibly poses a problem of damage to the ceramic substrate. In order to attain a high-level of surface flatness while preventing any damage to the ceramic substrate in a composite wiring board, therefore, it is preferred to perform a laminating step utilising a vacuum laminating process described below.

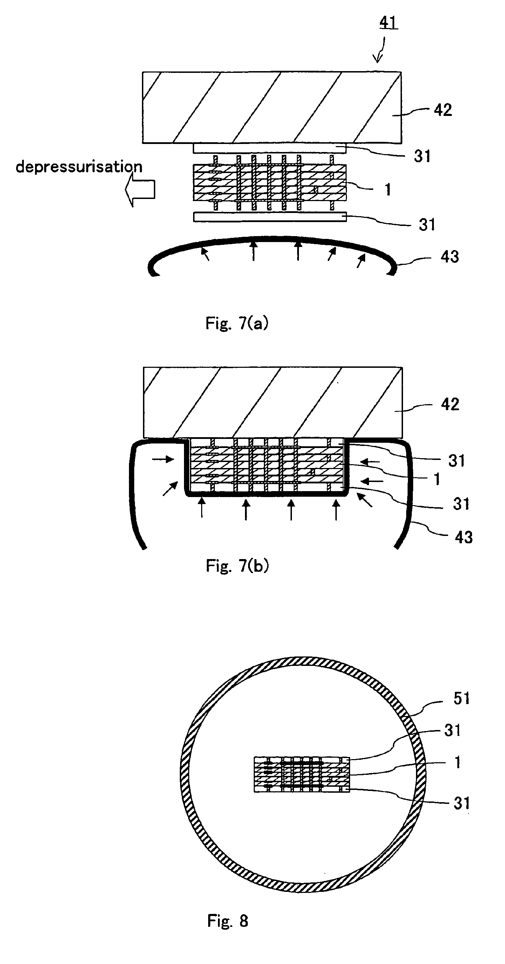

Resin sheets constituting the resin layers 2 and 3 are first laminated on the opposite sides of the ceramic substrate 1. In the present example, this lamination is performed by the use of the vacuum laminating process utilising a vacuum laminator 41 shown in Figure 7. The vacuum laminator 41 is fundamentally equipped with a heating flat plate 42 having a heater built therein and a silicone resin film 43 disposed below the heating flat plate 42 that are accommodated within a mould (not shown) having its interior spacing depressurised.

The resin layers are formed by the following procedure using the vacuum laminator 41. As shown in Figure 7(a), paired resin sheets 31 are disposed on the opposite sides (outermost layers) of the ceramic substrate, with the mould (not shown) opened, and these are disposed between the heating flat plate 42 and the silicone resin film 43.

The mould is then closed and, as shown in Figure 7(b), the air between the heating flat plate 42 and the silicone resin film 43 is discharged to depressurise the interior of the mould and, at the same time, heated and compressed air is supplied from below the silicone resin film 43 to swell the silicone resin film 43 and urge toward the heating flat plate 42 the laminate comprising the resin sheet 31, ceramic substrate 1 and resin sheet 31. The conditions of the lamination by the vacuum laminating process include a temperature of 80°C to 120°C, a pressure of 0.1 MPa to 0.8 MPa and a pressure-applying time of 30 sec to 120 sec. As a result, the resin sheets 31 are brought into intimate contact with and laminated on the ceramic substrate 1. The height of the sintered metal conductors 6 and the thickness of the resin sheets are appropriately set to pierce the sintered metal conductors 6 through the resin material of the resin sheets 31. Incidentally, while the vacuum laminator is described in JP-A HEI 11-320682, for example, there is no prior art disclosing that the vacuum laminator is applied to a composite wiring board comprising a ceramic layer and a resin layer.

Utilisation of the vacuum laminating process described above enables uniform application of appropriately low pressure as compared with the vacuum press etc. and production of lamination between the ceramic substrate 1 and the resin sheets 31 without inflicting any damage on the ceramic substrate 1. Since the side surfaces of the laminate comprising the resin sheets 31 and ceramic substrate 1 are pressurised via the silicone resin film 43, outflow of the resin from the side surfaces of the laminate is prevented and reduction in variation of the thickness and enhancement in flatness of the surface of the composite ceramic substrate can be realised. Furthermore, the utilisation of the vacuum laminating process enables suppression of occurrence of defects, such as poor lamination resulting from entanglement of air bubbles at the interfaces between the ceramic substrate 1 and the resin layers 2 and 3.

Though JP-A HEI 11-266080 applies the vacuum laminating process to lamination of an insulating resin film on an epoxy glass copper clad laminate plate, it does not refer to a ceramic substrate at all. JP-A HEI 11-266080 discloses a laminating apparatus performing lamination through passage between plural rolls. When this kind of lamination system is applied to a ceramic substrate, the ceramic substrate will be damaged to make it impossible to fabricate a composite ceramic substrate. On the other hand, the present invention uses a ceramic substrate as a subject matter and utilises the vacuum laminating process of the system shown in Figure 7, for example, to solve the problem of damage possibly entailed by the ceramic substrate and realise the formation of a composite substrate of a ceramic substrate and a resin layer.

The resin sheet 31 used for the formation of a resin layer is produced by the steps of mixing resin powder with an organic vehicle to produce slurry resin paste, using the doctor blade process etc. to apply the paste onto a support and drying the paste on the support. It is preferred that the resin material formed into a film on the support is brought to a state having sufficient fluidity during the course of lamination, e.g. a semi-hardened state (B-stage state). When a thermosetting resin is used as the resin material, it is heat-treated into the semi-hardened state. By bringing the resin material to a semi-hardened state, it is made possible to enhance the property of adhesion of the resin sheet 31 to the surface of the ceramic substrate 1 and the property of filling with respect to the asperity resulting from the presence of the sintered metal conductors and consequently materialise the further enhancement of the surface flatness of the composite wiring board finally obtained.

Though the film thickness of the resin material in the resin sheet 31 may be determined appropriately depending on the state of the surface of the ceramic substrate, it has to be larger than at least the height of the undulation or asperity on the surface of the ceramic substrate. It is therefore set to be 10 µm to 100 µm.

As the support constituting the resin sheet 31, a resin film of PET etc. or metal foil of copper etc. can be used.

When the vacuum laminating process is used to complete the lamination, from the standpoint of effectively obtaining the effect of damage prevention, the ceramic substrate 1 is preferred to have a small thickness relative to the substrate area. To be specific, assuming that the area of the ceramic substrate is expressed as s (mm²) and the thickness thereof as *t* (mm), it is preferred that a ceramic substrate having a ratio of *s*/ *t* in the range of 10000 to 250000 is used as the ceramic substrate 1. If the ratio falls short of the above range, i.e. when the thickness is excessively large relative to the area, no damage is inflicted on the ceramic substrate. Inversely, if the ratio exceeds the above range, i.e. when the thickness is excessively small relative to the area, there is a fair possibility of the effect of damage prevention being not obtained satisfactorily.

Incidentally, preparatory to the resin sheet lamination, the ceramic substrate 1 may be subjected to surface treatment. Before laminating the resin sheets on the surfaces of the ceramic substrate 1, the surfaces of the ceramic substrate 1 is treated with a silane coupling agent, for example, to enhance the adaptability of lamination between the resin material and the ceramic substrate and make it possible to enhance the property of adhesion of the resin layers 2 and 3 to the ceramic substrate 1.

After the lamination, the resin material constituting the resin sheet 31 is caused to set. When the resin layer is formed of a thermosetting resin, for example, the vacuum laminator 41 is used to laminate the resin sheet 31 and further used to apply heat and pressure. As a result, the resin material is caused to set, thereby forming the resin layers 2 and 3 on surfaces of the ceramic substrate 1.

The thermosetting conditions when utilising the vacuum laminator 41 have to be appropriately determined in accordance with the kind of resin layers (resin material of the resin sheets). For example, the temperature is set to be 150°C to 180°C. The pressure at the time of thermosetting may be 0.1 MPa to 0.8 MPa. Though the time required for the pressure application varies depending on the kind of the resin layer, it is in the range of around 1 to 10 hours.

The manufacturing method described above forms the resin layers 2 and 3 on the surfaces of the ceramic substrate, thereby obtaining the composite wiring board as shown in Figure 1.

When the sintered metal conductors 6 fail to pierce through the resin layers 2 and 3 after having been formed, the surfaces of the resin layers 2 and 3 may be ground to expose part of the sintered metal conductors 6 to the surfaces of the resin layers 2 and 3.

Also, surface conductors may be formed on the surfaces of the resin layers 2 and 3 as occasion demands. The method of forming the surface conductors is not particularly limited. However, the surface conductors can be formed by a method comprising plating the surfaces of the resin layers with Cu, for example, and then processing the Cu plating into a predetermined shape using the photolithographic technique and etching. When a resin film of PET is used as a support for the resin sheet 31, for example, the surface conductors may be formed after exfoliation of the resin film. On the other hand, when metal foil of Cu etc. is used as the support, the photolithographic technique and etching are adopted to pattern the metal foil, thereby enabling formation of the surface conductors.

According to the manufacturing method of the present example as described above, sintered metal conductors 6 of a columnar shape, for example, are formed on the surface of a ceramic substrate 1 and resin layers 2 and 3 are then formed so that the sintered metal conductors may pierce through the resin layers. As a result, it is not required to take the step of forming through holes with the aim of forming in the resin layers 2 and 3 vias for interlayer connection or for heat radiation. Therefore, the entire process is simplified and, at the same time, no high-precision alignment for forming through holes is required. In addition, the sintered metal conductors 6 can be used as marks for alignment for forming surface conductors on the surfaces of the resin layers 2 and 3. Therefore, it is possible to easily manufacture a composite wiring board with higher precision.

Furthermore, the aforementioned manufacturing method utilizes the vacuum laminating process capable of isotropic application of heat and pressure under low pressure, the resin sheets can be laminated on the ceramic substrate without inflicting any damage on the ceramic substrate to thereby fabricate a composite wiring board without any damage inflicted thereon. The composite wiring board thus fabricated has prevented outflow of resin from the end faces thereof exhibited small fluctuation in thickness. Furthermore, lamination of relatively thick resin sheets enables the asperity or undulation to be flattened to produce excellent flatness and smoothness of the resin layer surfaces.

When manufacturing the composite wiring board, it is preferred that the step of resin curing is taken while adopting pressure application using a heating atmosphere as a medium. Specifically, the laminate having the resin sheets 31 laminated on the ceramic substrate 1 is taken out of the vacuum laminator 41 and subjected to resin material curing using a temperature-and-pressure application apparatus as shown in Figure 8.

The temperature-and-pressure application apparatus is equipped with a pressure application chamber 51 and is capable of applying isotropic pressure to an object to be treated while using a heating atmosphere as a medium. The laminate comprising the resin sheets 31 and ceramic substrate taken out of the vacuum laminator 41 is accommodated in the pressure application chamber 51, and the interior of the pressure application chamber 51 is heated and the pressure therein is simultaneously heightened. Since the pressure application with the heating atmosphere used as the medium enables the curing of the resin material to proceed while squashing the volatile components or air bubbles existing therein, the expansion of the resin layers 2 and 3 can be prevented to make the flatness and smoothness of the composite wiring board surface better. In addition, since the pressure application within the pressure application chamber 51 using the heating atmosphere as the medium can speed up the curing of the resin material, the time required for the curing of the resin material can be shortened. Though the time for requiring the curing varies depending on the kind of the resin layers 2 and 3, a short period of time in the range of around one to three hours will suffice to enhance the productivity of composite wiring boards.

Though the curing conditions when using the temperature-and-pressure application apparatus may appropriately be set in accordance with the kind of the resin layers 2 and 3 etc., the temperature is set to be in the range of 150°C to 250°C, for example. The pressure in this case may be in the range of around 0.1 MPa to 1.5 MPa. The atmosphere may be air, nitrogen, a mixed gas thereof or other such gas generally used for heat application and pressure application of this kind.

The technique of pressure application using the heating atmosphere as a medium for the purpose of curing a resin composition is a known technique as described in JP-A 2003-277479, for example. However, the prior art intends to make a metal material, such as copper foil, an aluminium plate, stainless steel plate, etc., and a resin composition composite. Utilisation of this technique to a ceramic substrate falls outside its assumption, i.e. is not envisaged. When manufacturing a composite wiring board comprising a special combination of a ceramic substrate and resin layers, it is important first to use a vacuum lamination process to attain the lamination thereof and apply pressure using a heating atmosphere as a medium to complete resin curing.

Incidentally, in the foregoing description, the pressure application using the heating atmosphere as a medium is not indispensable to the present invention. Even when performing resin material curing in the heating atmosphere at normal pressures, the curing time can be shortened. From the viewpoint of enhancing the filling property of the resin material, however, desirably, the pressure application is used as well. When performing the resin material curing in the heating atmosphere without adopting the pressure application, a cleaned oven or a hot air dryer can be used.

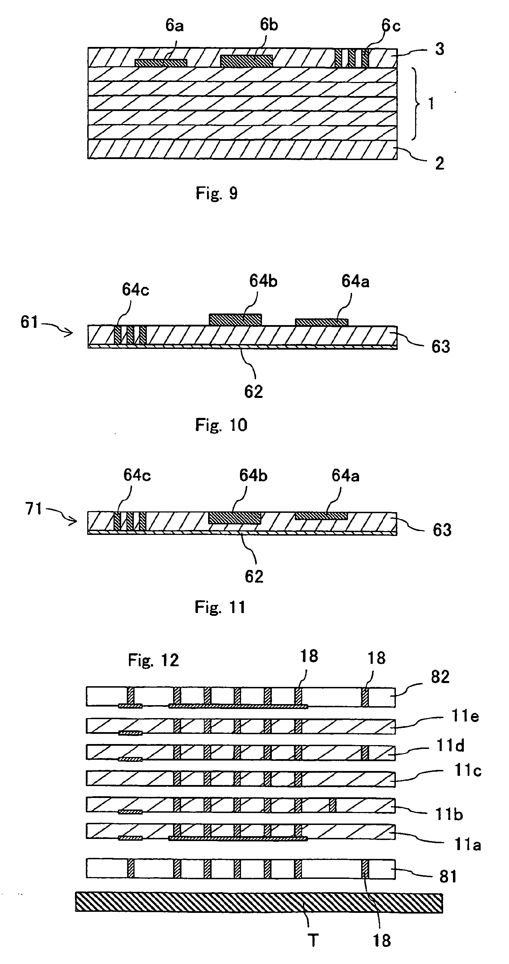

While in the composite wiring board of the first example, the columnar sintered metal conductors 6 having the same height have been formed on the surface of the ceramic substrate 1, sintered metal conductors 6a to 6c having different heights may be formed on the surface of the ceramic substrate 1 as shown in Figure 9. A composite wiring board of the second example and a manufacturing method thereof will be described. It is noted that the description of the same parts as in the first example will be omitted and that the internal conductors are not shown in Figure 9.

In the composite wiring board of the second example, the sintered metal conductor 6 includes columnar sintered metal conductors 6c piercing through a resin layer 3 and sintered metal conductors 6a and 6b different in height from the surface of a ceramic substrate 1 from the columnar sintered metal conductors 6c. In Figure 9, for example, formed are three kinds of sintered metal conductors 6, i.e. lowest sintered metal conductors 6a, sintered metal conductors 6b higher than the lowest sintered metal conductors 6a and columnar sintered metal conductors 6c higher than the sintered metal conductors 6a and 6b and piercing through the resin layer 3. The heights of the sintered metal conductors 6 are appropriately determined in accordance with functions to be exhibited by the sintered metal conductors and may be set in the range of 5 µm to 200 µm, for example. The difference in height of the sintered metal conductors used herein excludes a minor difference in height of a level of a variation possibly occurring during the course of manufacture.

Figure 10 shows a sheet 61 for formation of conductors used for forming sintered metal conductors 6a to 6c different in height from one another. The sheet 61 for formation of conductors is obtained by the steps of forming on a support 62 a green sheet for shrinkage suppression, for example, as a sheet 63 having a shrinkage-suppressing effect, then forming through holes in the sheet 63 having a shrinkage-suppressing effect at positions corresponding to those of the sintered metal conductors 6c piercing through the resin layer 3 and, at the same time, filling the through holes with conductive paste 64c. Though the method of filling the conductive paste is not particularly limited, screen printing can be raised, for example.

In the sheet 61 for formation of conductors, conductive paste 64a and 64b are retained on the surface of the sheet 63 having a shrinkage-suppressing effect at positions corresponding to those of the sintered metal conductors 6a and 6b not piercing through the resin layer 3. The conductive paste 64a and 64b are formed in predetermined patterns by printing, such as the screen printing, and the heights thereof are controlled through the laminate printing.

The composite wiring board shown in Figure 9 is fabricated by the following procedure. The green sheets 11a to 11e for a substrate and the sheet 61 for formation of conductors shown in Figure 10 are disposed as overlapping each other. At this time, the printed surface of the sheet 61 for formation of conductors, i.e. the conductive paste 64a and 64b retained on the surface of the sheet 61 for conductor formation, is laminated in contact with the green sheet 11e for a substrate. In the second example, since the sintered metal conductors 6a to 6c are formed on only one surface of the ceramic substrate 1, a green sheet for shrinkage suppression having no conductive paste filled therein is disposed on the side of the green sheets 11a to 11e for a substrate opposite the side thereof in contact with the sheet 61 for formation of conductors. Thereafter, the resultant laminate is fired and the fired product of the green sheet for shrinkage suppression is removed, with the result that sintered metal conductors 6a to 6c different in height are formed on the surface of the ceramic substrate 1.

The resin layers 2 and 3 are then formed on the surfaces of the ceramic substrate 1 to obtain the composite wiring board shown in Figure 9.

The composite wiring board of the second example is provided with the sintered metal conductors 6c piercing through the resin layer 2 and sintered metal conductors 6a and 6b different in height from the surface of the ceramic substrate 1. In view of the difference in height for example, the lowest sintered metal conductor 6a is allowed to function as a capacitor electrode, the sintered metal conductor 6b higher than the conductor 6a as a large-current wiring and the highest columnar sintered metal conductors 6c as vias for interlayer connection, vias for heat radiation or as marks for alignment in the formation of surface conductors of the resin layer 3. Thus, the resin layer 3 can serve as a multifunction resin layer. By making the heights of the sintered metal conductors 6 different, therefore, it is possible to provide a composite wiring board which is further multifunctional and miniaturised.

A composite wiring board of the third example uses, in place of the sheet 61 for formation of conductors in the second example, a sheet 71 for formation of conductors that has a sheet 63 having a shrinkage-suppressing effect and provided therein with concaves in which conductive paste 64a ad 64b are filled.

The sheet 71 for formation of conductors is fabricated by the following procedure. A green sheet for shrinkage suppression is first formed as a sheet 63 having a shrinkage-suppressing effect on a support 62 as shown in Figure 11, and through holes are formed therein at predetermined positions corresponding to those of the columnar sintered metal conductors 6c. In addition, concavities of depths corresponding to the heights of the sintered metal conductors 6a and 6b smaller than that of the sintered metal conductors 6c are formed in the sheet 63 having a shrinkage-suppressing effect in the present example. Thus, the depths of the concavities define the heights of the sintered metal conductors 6a and 6b, respectively. Though the processing method for the formation of the concavities and through holes is not particularly limited, examples thereof include a press working by means of moulds, punching processing and laser processing, for example. These processing methods prove to be preferable because the depths and shapes of the concavities and the shapes of the through holes are easy to control.

The concavities and through holes are filled with conductive paste. Though the method of filling the conductive paste is not particularly limited, screen printing can be cited, for example. As a result, the sheet 71 for formation of conductors that have conductive paste 64a, 64b and 64c filled therein is obtained.

The green sheets 11a to 11e for a substrate and the sheet 71 for formation of conductors shown in Figure 11 are disposed as overlapping each other. At this time, the printed surface of the sheet 71 for formation of conductors, i.e. the conductive paste 64a and 64b filled in the concaves of the sheet 71 for conductor formation, is laminated in contact with the green sheet 11e for a substrate. Thereafter, the resultant laminate is fired and the fired product of the green sheet for shrinkage suppression is removed, with the result that a plurality of sintered metal conductors 6a to 6c different in height are formed on the surface of the ceramic substrate 1.

The resin layers 2 and 3 are then formed on the surfaces of the ceramic substrate 1 to obtain the composite wiring board shown in Figure 9.

Since the second example requires the laminate printing when forming the sintered metal conductors 6a and 6b (conductive paste 64a and 64b) different in height, the heights are difficult to control and the printing process is liable to be cumbersome and complicated.

On the other hand, since the third example determines the heights of the conductive paste 64a and 64b and eventually the heights of the sintered metal conductors 6a and 6b in accordance with the depths of the concaves formed in the sheet 63 having a shrinkage-suppressing effect, the laminate printing is unnecessary to perform, thereby enabling the printing process to be simplified. Furthermore, the control in height of the conductive paste based on the control in depth of the concaves is advantageous because it is easier than the control in height of the conductive paste based on the laminate printing.

A composite wiring board of the fourth example uses a sheet containing calcium carbonate (CaCO₃) as the sheet having the shrinkage-suppressing effect that constitutes a sheet for formation of conductors.

The sheet for formation of conductors using the sheet containing calcium carbonate is obtained by the steps of forming the sheet containing calcium carbonate on the support, forming through holes in the sheet on the support and filling the through holes with conductive paste. The conductive paste may be printed on the surface of the sheet for formation of conductors using the sheet containing calcium carbonate or be laminate-printed thereon. Otherwise, the conductive paste may be filled in concavities having been formed in the sheet for formation of conductors (the sheet containing calcium carbonate).

The sheet containing calcium carbonate is formed through formation, on the support, of calcium carbonate-containing paste having a binder and calcium carbonate mixed with each other and formation of the paste into a film sheet.

As the binder contained in the sheet containing calcium carbonate, it is possible to optionally use a resin material, for example. However, a material thermally decomposable rapidly during the course of firing is preferably used. Particularly, a material easier to thermally decompose than the organic vehicle contained in the green sheet for a substrate or having a level in thermal decomposition the same as that of the vehicle contained in the green sheet for a substrate is preferred for use.

In the present example, as shown in Figure 12, sheets 81 and 82 for formation of conductors using the sheets containing calcium carbonate and the green sheets 11a to 11e are fired in their laminated state. Incidentally, pressure may be applied to these sheets in their laminated state. As a consequence of the firing, the conductive paste 18 filled in the through holes of the sheets 81 and 82 for formation of conductors are transferred onto the ceramic substrate to obtain a ceramic substrate provided on the surface thereof with sintered metal conductors. Resin sheets are formed on the opposite surfaces of the ceramic substrate to obtain a composite wiring board.

Since the sheet containing calcium carbonate is used as the sheet having the shrinkage-suppressing effect, it is made possible to prevent the fired product of the sheet having the shrinkage-suppressing effect from remaining as a residual on the surface of the ceramic substrate (particularly on the surface of the conductive patterns). The fired product of the sheet having the shrinkage-suppressing effect is an insulator and, when the insulator remains as the residual on the conductive pattern, it constitutes an obstacle to current flow. By using the sheet containing calcium carbonate as the sheet having the shrinkage-suppressing effect, however, the residual scarcely remains to enable the manufacture of a composite wiring board excelling in electrical connection reliability (current flow reliability) even without performing washing. While the problem of the residual can be solved without washing out the fired ceramic substrate, as described above, it is arbitrary to adopt cleaning, such as ultrasonic cleaning, for the fired ceramic substrate.

The dimensional accuracy and flatness of the fired ceramic substrate can be enhanced by dint of the shrinkage-suppressing effect the sheet containing calcium carbonate used for the sheet for formation of conductors has though the enhancement is not so large as compared with the dimensional accuracy and flatness realised by the use of green sheet for shrinkage suppression.

In the method for manufacturing a composite wiring board according to the present invention, firing is performed in a state wherein sheets having a shrinkage-suppressing effect are further laminated on the outside of the sheets for formation of conductors (sheets containing calcium carbonate that are sheets having the shrinkage-suppressing effect) used in the fourth example.

As the sheet having the shrinkage-suppressing effect, green sheets for shrinkage suppression and sheets containing calcium carbonate, zirconium oxide or aluminium oxide are available. Of these, the green sheets for shrinkage suppression, when being used, bring about a larger effect of suppressing the shrinkage of the green sheets for a substrate. As the green sheets for shrinkage suppression, those similar to the green sheets for shrinkage suppression used for the sheets for formation of conductors used in the first example can be used. That is to say, the green sheets for shrinkage suppression containing a sintering aid and at least one member selected from the group consisting of quartz, cristobalite and tridymite or green sheets for shrinkage suppression containing tridymite that is sintered by firing for obtaining a ceramic substrate and an oxide that is not sintered by the firing can be used as the sheets for shrinkage suppression. As the sheets containing calcium carbonate, those similar to the sheets containing calcium carbonate used in the fourth embodiment as the sheets for formation of conductors.

Use of sheets containing zirconium oxide or aluminium oxide makes the stress exerted on the sintered metal conductors smaller as compared with the case of using the sheets containing tridymite, for example, for shrinkage suppression to make it effective for decreasing the number of the sintered metal conductors being deteriorated.

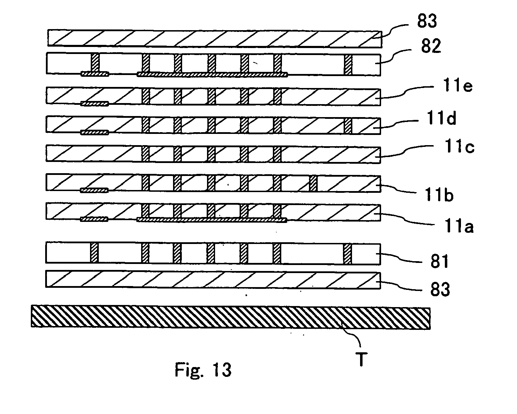

As shown in Figure 13, sheets 81 and 82 for formation of conductors using the sheets containing calcium carbonate are disposed on the opposite sides of a plurality of laminated sheets 11a to 11e for a substrate, and sheets 83 having the shrinkage-suppressing effect are disposed on the outside thereof. The firing is conducted in this state. Incidentally, pressure may be applied to the sheets laminated. As a consequence of the firing, the conductive paste 18 filled in the through holes of the sheets 81 and 82 for formation of conductors are transferred onto the ceramic substrate to obtain a ceramic substrate provided on the surface thereof with the sintered metal conductors. The resin layers are formed on the opposite surfaces of the ceramic substrate thus obtained to obtain a composite wiring board.

The lamination of the outside of the sheets 81 and 82 for formation of conductors using the sheets containing calcium carbonate with the sheets 83 having the shrinkage-suppressing effect enables the product of the sintered sheets having the shrinkage-suppressing effect to be prevented from remaining as a residual on the ceramic substrate (particularly on the surface of the conductive pattern) in the same manner as in the case of using the sheets 81 and 82 for formation of conductors alone. In particular, the sheets 83 having the shrinkage-suppressing effect serve to allow the sheets 81 and 82 for formation conductors to spontaneously exfoliate at the boundaries with the ceramic substrate, thereby making the removal of the residual easier.

Furthermore, a combination of the sheets for formation of conductors using the sheets containing calcium carbonate with the sheets having the shrinkage-suppressing effect, particularly the green sheets for shrinkage suppression, sufficiently exerts the binding force on the substrate, thereby enhancing the dimensional accuracy and flatness as compared with the case using the sheets for formation of conductors alone.

The above description is directed to the composite wiring board and the manufacturing method thereof. So, while the description is directed to a ceramic substrate having a multilayer structure as the ceramic substrate, the same effect can be obtained in the case of using a substrate having a single layer structure.

It is noted that the present invention includes a composite wiring board having resin layers laminated on the opposite surfaces of the ceramic substrate and that having a resin layer laminated on one surface of the ceramic substrate on which the sintered metal conductors are formed.

Furthermore, in fabricating the ceramic substrate constituting the composite wiring board, various sheets for formation of conductors described herein can be combined.

Examples of the present invention will be described herein below based on the following experimental results.

First, as a ceramic material for a substrate, an alumina-glass-based dielectric material was prepared. The ceramic material was mixed with an organic binder and an organic solvent and the doctor blade process was used to fabricate green sheets for a substrate each having a thickness of 40 µm. The substrate green sheets were formed therein with via holes in which conductive paste was filled, thereby forming vias. The substrate green sheets were further formed therein with conductive paste printed into a predetermined shape, thereby forming internal layer patterns. The conductive paste was prepared using Ag grains having an average particle diameter of 1.5 µm as conductive materials and mixing the same with an organic binder and an organic solvent.

A tridymite-silica-based material was prepared as a material for shrinkage suppression and mixed with an organic binder and an organic solvent and the mixture was subjected to the doctor blade process to fabricate a green sheet for shrinkage suppression having a thickness of 50 µm. The shrinkage suppression green sheet was formed therein with through holes 40 µm in diameter at pitches of 80 µm using a carbon dioxide laser. Conductive paste was then filled in the through holes by means of screen printing to obtain a sheet A for formation of conductors.

The conductive paste was prepared using Ag grains having an average particle diameter of 1.5 µm as conductive materials and mixing the same with an organic binder and an organic solvent.

A tridymite-silica-based material was prepared as a material for shrinkage suppression and mixed with an organic binder and an organic solvent and the mixture was subjected to the doctor blade process to fabricate a green sheet for shrinkage suppression having a thickness of 125 µm. The shrinkage suppression green sheet was formed therein with through holes 100 µm in diameter at pitches of 300 µm using a punching processing. The conductive paste used for obtaining the sheet *A* for formation of conductors was then filled in the through holes by means of screen printing to obtain a sheet *B* for formation of conductors.

Calcium carbonate was mixed with an organic binder (acrylic resin), a plasticiser, a dispersant and an organic binder to prepare calcium carbonate-containing paste. The paste was subjected to the doctor blade process to fabricate a calcium carbonate-containing sheet having a thickness of 50 µm. The calcium carbonate-containing sheet was formed therein with through holes 40 µm in diameter at pitches of 80 µm using an UV-YAG laser. The conductive paste used for obtaining the sheet *A* for formation of conductors was then filled in the through holes by means of screen printing to obtain a sheet *C* for formation of conductors.

Calcium carbonate was mixed with an organic binder (acrylic resin), a plasticiser, a dispersant and an organic binder to prepare calcium carbonate-containing paste. The paste was subjected to the doctor blade process to fabricate a calcium carbonate-containing sheet having a thickness of 100 µm. The calcium carbonate-containing sheet was formed therein with through holes 100 µm in diameter at pitches of 250 µm using the punching processing. The conductive paste used for obtaining the sheet *A* for formation of conductors was then filled in the through holes by means of screen printing to obtain a sheet *D* for formation of conductors.

Calcium carbonate was mixed with an organic binder (acrylic resin), a plasticiser, a dispersant and an organic binder to prepare calcium carbonate-containing paste. The paste was subjected to the doctor blade process to fabricate a calcium carbonate-containing sheet having a thickness of 60 µm. The calcium carbonate-containing sheet was formed therein with through holes 100 µm in diameter at pitches of 250 µm using the punching processing. The conductive paste used for obtaining the sheet *A* for formation of conductors was then filled in the through holes by means of screen printing to obtain a sheet *E* for formation of conductors.

A tridymite-silica-based material was prepared as a material for shrinkage suppression and mixed with an organic binder and an organic solvent. The mixture was subjected to the doctor blade process to fabricate a 75 µm-thick green sheet *A* having a shrinkage-suppressing effect.

A tridymite-silica-based material was prepared as a material for shrinkage suppression and mixed with an organic binder and an organic solvent. The mixture was subjected to the doctor blade process to fabricate a 125 µm-thick green sheet *B* having a shrinkage-suppressing effect.

As a sheet *C* having a shrinkage-suppressing effect, a sheet containing zirconium oxide was fabricated. Specifically, a zirconium oxide material prepared was mixed with an organic binder and an organic solvent to fabricate a 75 µm-thick sheet in accordance with the doctor blade process.

As a sheet *D* having a shrinkage-suppressing effect, a sheet containing aluminium oxide was fabricated. Specifically, an aluminum oxide material prepared was mixed with an organic binder and an organic solvent to fabricate a 75 µm-thick sheet in accordance with the doctor blade process.

Resin sheets were fabricated using the doctor blade process in which a resin coat was applied onto a PET film, dried and heat-treated so that the resin coat might be in a semihardened state (B-stage state). The resin coat contained vinylbenzyl resin as a resin material and 30 vol % of spherical silica as a filler and prepared using a ball mill performing dispersing and mixing. The resin material on the PET film was adjusted to have a thickness of approximately 45 µm or 60 µm.

### Example 1:

The plural green sheets for a substrate fabricated were laminated to form a multilayer structure. The multilayer structure, the conductor formation sheet *A* on one surface of the multilayer structure and a shrinkage suppression green sheet having a thickness of 50 µm on the other surface thereof were laminated to obtain a laminate. The laminate was placed in an ordinary mould having upper and lower flat punches, pressurised at 700 kg/cm² for seven minutes and then fired at 900°C. Sintered products of the conductor formation sheet A and shrinkage suppression green sheet disposed on the opposite sides of the multilayer structure of the substrate green sheets as the result of the firing were removed by means of a sandblast (sold under the name of PNEUMA-BLASTER and produced by Fuji Manufacturing Co., Ltd.) using alumina abrasives #1000 and an air pressure of 0.17 MPa to 0.2 MPa.

As a result, a ceramic substrate provided on the surfaces thereof with columnar sintered metal conductors having a height of around 40 µm was obtained. The fired ceramic substrate as a whole exhibited no shrinkage in the plane direction thereof and great shrinkage only in the thickness direction.

A resin sheet having a thickness of 45 µm was disposed on each of the surfaces of the ceramic substrate having the sintered metal conductors formed thereon and laminated therewith using a vacuum laminator (VAII-700 type produced by Meiki Co., Ltd.). The laminating conditions included a temperature of 110°C, a pressure-applying time of 60 minutes and a pressure of 0.5 MPa during the course of the lamination. The vacuum laminator was further used to cure the resin material. The curing conditions included a temperature of 180°C, a pressure of 0.5 MPa and a curing time of four hours.

The cured resin surface of the substrate was ground by means of wet blasting (produced by Macoho Co., Ltd.) using alumina abrasives #2000 and an air pressure of 0.15 MPa to 0.17 MPa to expose the upper surfaces of the sintered metal conductors to the resin layer surface. Consequently, the composite wiring board of Example 1 was obtained.

### Example 2:

The plural green sheets for a substrate fabricated were laminated to form a multilayer structure. The multilayer structure, the conductor formation sheet *B* on one surface of the multilayer structure and a shrinkage suppression green sheet having a thickness of 125 µm on the other surface thereof were laminated to obtain a laminate. The laminate was pressurised and fired under the same conditions as in Example 1. Sintered products of the conductor formation sheet *B* and shrinkage suppression green sheet disposed on the opposite sides of the multilayer structure of the substrate green sheets as the result of the firing were removed by means of wet blasting (produced by Macoho Co., Ltd.) using alumina abrasives #2000 and an air pressure of 0.17 MPa to 0.2 MPa.

As a result, a ceramic substrate provided on the surfaces thereof with columnar sintered metal conductors having a height of around 100 µm was obtained. The fired ceramic substrate as a whole exhibited no shrinkage in the plane direction thereof and great shrinkage only in the thickness direction thereof.

The two resin sheets each of a thickness of 60 µm were laminated to produce a laminated resin sheet having a thickness of 120 µm. The laminated resin sheet having a thickness of 120 µm was disposed on each of the surfaces of the ceramic substrate having the sintered metal conductors formed thereon and laminated therewith in the same manner as in Example 1. The laminating conditions were the same as in Example 1. A vacuum laminator was used to cure the resin material. The curing conditions were the same as in Example 1.

The cured resin surface of the substrate was ground by means of a grinder (produced by DISCO Corporation) at a peripheral wheel speed of 1 µm/sec to grind the resin layer by 20 µm and expose the upper surfaces of the sintered metal conductors to the resin layer surface. Consequently, the composite wiring board of Example 2 was obtained.

### Example 3:

The plural green sheets for a substrate fabricated were laminated to form a multilayer structure. The multilayer structure, the conductor formation sheet *C* on one surface of the multilayer structure and a sheet containing calcium carbonate and having a thickness of 50 µm on the other surface thereof were laminated to obtain a laminate. The laminate was pressurised and fired under the same conditions as in Example 1. Sintered products of the conductor formation sheet *A* and sheet containing calcium carbonate disposed on the opposite sides of the multilayer structure of the substrate green sheets as the result of the firing were removed by means of ultrasonic cleaning at a frequency of 45 kHz for 60 seconds.

As a result, a ceramic substrate provided on the surfaces thereof with columnar sintered metal conductors having a height of around 40 µm was obtained. The fired ceramic substrate as a whole was suppressed from being shrunken in the plane direction thereof and greatly shrunken only in the thickness direction thereof. The degree of shrinkage after the firing was in the approximate range of +2.6% to +3.0%. The ceramic substrate thus obtained measured 150 mm x 150 mm x 0.1 mm.

A resin sheet having a thickness of 45 µm was disposed on each of the surfaces of the ceramic substrate having the sintered metal conductors formed thereon and laminated therewith in the same manner as in Example 1. The laminating conditions were the same as in Example 1. The vacuum laminator was then used to cure the resin material. The curing conditions were the same as in Example 1.

The cured resin surface of the substrate was ground by means of wet blasting (produced by Macoho Co., Ltd.) using alumina abrasives #2000 and an air pressure of 0.15 MPa to 0.17 MPa to expose the upper surfaces of the sintered metal conductors to the resin layer surface. Consequently, the composite wiring board of Example 3 was obtained.

### Example 4:

Firing was performed in a state wherein the sheet *A* having a shrinkage-suppressing effect was disposed on the outside of the conductor formation sheet *C.* Specifically, the multilayer structure of plural laminated green sheets for a substrate and the combination of the conductor formation green sheet *C* with the sheet *A* having a shrinkage-suppressing effect disposed on each of the opposite surfaces of the multilayer structure were laminated to obtain a laminate. The laminate was pressurised and fired under the same conditions as in Example 1. Sintered products of the conductor formation sheet *C* and sheet *A* having a shrinkage-suppressing effect disposed on the opposite sides of the multilayer structure of the substrate green sheets as the result of the firing were removed by means of a sandblast (sold under the name of PNEUMA-BLASTER and produced by Fuji Manufacturing Co., Ltd.) using alumina abrasives #1000 and an air pressure of 0.17 MPa to 0.2 MPa.

As a result, a ceramic substrate provided on the surfaces thereof with columnar sintered metal conductors having a height of around 45 µm was obtained. The fired ceramic substrate as a whole exhibited no shrinkage in the plane direction thereof and great shrinkage only in the thickness direction thereof. The degree of shrinkage after the firing was in the approximate range of +0.4% to +0.5% that was lower than that in Example 3.

A resin sheet having a thickness of 45 µm was disposed on each of the surfaces of the ceramic substrate having the sintered metal conductors formed thereon and laminated therewith in the same manner as in Example 1. The laminating conditions were the same as in Example 1. The vacuum laminator was then used to cure the resin material. The curing conditions were the same as in Example 1.

The cured resin surface of the substrate was ground by means of wet blasting (produced by Macoho Co., Ltd.) using alumina abrasives #2000 and an air pressure of 0.15 MPa to 0.17 MPa to expose the upper surfaces of the sintered metal conductors to the resin layer surface. Consequently, the composite wiring board of Example 4 was obtained.

### Example 5:

Firing was performed in a state wherein the sheet *B* of a thickness of 125 µm having a shrinkage-suppressing effect was disposed on the outside of the conductor formation sheet *C.* Specifically, the multilayer structure of plural laminated green sheets for a substrate and the combination of the conductor formation green sheet *C* with the sheet *B* having a compression-suppressing effect disposed on each of the opposite surfaces of the multilayer structure were laminated to obtain a laminate. The laminate was pressurised and fired under the same conditions as in Example 1. Sintered products of the conductor formation sheet C and sheet B having a shrinkage-suppressing effect disposed on the opposite sides of the multilayer structure of the substrate green sheets as the result of the firing were removed by means of a sandblast (sold under the name of PNEUMA-BLASTER and produced by Fuji Manufacturing Co., Ltd.) using alumina abrasives #1000 and an air pressure of 0.17 MPa to 0.2 MPa.

As a result, a ceramic substrate provided on the surfaces thereof with columnar sintered metal conductors having a height of around 45 µm was obtained. The fired ceramic substrate as a whole exhibited no shrinkage in the plane direction thereof and great shrinkage only in the thickness direction thereof. The degree of shrinkage after the firing was in the approximate range of +0.2% to +0.3% that was lower than that in Example 4.

A resin sheet having a thickness of 45 µm was disposed on each of the surfaces of the ceramic substrate having the sintered metal conductors formed thereon and laminated therewith in the same manner as in Example 1. The laminating conditions were the same as in Example 1. The vacuum laminator was then used to cure the resin material. The curing conditions were the same as in Example 1.

The cured resin surface of the substrate was ground by means of wet blasting (produced by Macoho Co., Ltd.) using alumina abrasives #2000 and an air pressure of 0.15 MPa to 0.17 MPa to expose the upper surfaces of the sintered metal conductors to the resin layer surface. Consequently, the composite wiring board of Example 5 was obtained.

### Example 6:

Firing was performed in a state wherein the sheet *B* of a thickness of 125 µm having a shrinkage-suppressing effect was disposed on the outside of the conductor formation sheet *D*. Specifically, the multilayer structure of plural laminated green sheets for a substrate and the combination of the conductor formation green sheet *D* with the sheet *B* having a shrinkage-suppressing effect disposed on each of the opposite surfaces of the multilayer structure were laminated to obtain a laminate. The laminate was pressurised and fired under the same conditions as in Example 1. Sintered products of the conductor formation sheet *D* and sheet *B* having a shrinkage-suppressing effect disposed on the opposite sides of the multilayer structure of the substrate green sheets as the result of the firing were removed by means of wet blasting (produced by Macoho Co., Ltd.) using alumina abrasives #2000 and an air pressure of 0.17 MPa to 0.2 MPa.

As a result, a ceramic substrate provided on the surfaces thereof with columnar sintered metal conductors having a height of around 85 µm was obtained. The fired ceramic substrate as a whole exhibited no shrinkage in the plane direction thereof and great shrinkage only in the thickness direction thereof. The degree of shrinkage after the firing was in the approximate range of +0.7% to +0.8% that was higher than that in Example 5.

Two resin sheets each having a thickness of 45 µm were disposed on each of the surfaces of the ceramic substrate having the sintered metal conductors formed thereon and laminated therewith in the same manner as in Example 1. The laminating conditions were the same as in Example 1. The vacuum laminator was then used to cure the resin material. The curing conditions were the same as in Example 1.

The cured resin surface of the substrate was ground by means of a grinder (produced by DISCO Corporation) at a peripheral wheel speed of 1 µm/sec to grind the resin layer by 20 µm and expose the upper surfaces of the sintered metal conductors to the resin layer surface. Consequently, the composite wiring board of Example 6 was obtained.

### Example 7:

Firing was performed in a state wherein a sheet C having a shrinkage-suppressing effect was disposed on the outside of the conductor formation sheet *E*. Specifically, the multilayer structure of plural laminated green sheets for a substrate and the combination of the conductor formation sheet *E* with the sheet *C* having a compression-suppressing effect disposed on each of the opposite surfaces of the multilayer structure were laminated to obtain a laminate. The laminate was pressurised and fired under the same conditions as in Example 1. Sintered products of the conductor formation sheet *E* and sheet *C* having a shrinkage-suppressing effect disposed on the opposite sides of the multilayer structure of the substrate green sheets as the result of the firing were removed by means of wet blasting (produced by Macoho Co., Ltd.) using alumina abrasives #2000 and an air pressure of 0.17 MPa to 0.2 MPa.

As a result, a ceramic substrate provided on the surfaces thereof with columnar sintered metal conductors having a height of around 55 µm was obtained. The fired ceramic substrate as a whole exhibited no shrinkage in the plane direction thereof and great shrinkage only in the thickness direction thereof. The degree of shrinkage after the firing was in the approximate range of +0.1% to +0.3%.

A resin sheet having a thickness of 60 µm were disposed respectively on the surfaces of the ceramic substrate having the sintered metal conductors formed thereon and laminated therewith in the same manner as in Example 1. The laminating conditions were the same as in Example 1. The vacuum laminator was then used to cure the resin material. The curing conditions were the same as in Example 1.

The cured resin surface of the substrate was ground by means of a grinder (produced by DISCO Corporation) at a peripheral wheel speed of 1 µm/sec to grind the resin layer by 20 µm and expose the upper surfaces of the sintered metal conductors to the resin layer surface. Consequently, the composite wiring board of Example 7 was obtained.

### Example 8:

Firing was performed in a state wherein a sheet *D* having a shrinkage-suppressing effect was disposed on the outside of the conductor formation sheet *E.* Specifically, the multilayer structure of plural laminated green sheets for a substrate and the combination of the conductor formation sheet *E* with the sheet *D* having a compression-suppressing effect disposed on each of the opposite surfaces of the multilayer structure were laminated to obtain a laminate. The laminate was pressurised and fired under the same conditions as in Example 1. Sintered products of the conductor formation sheet *E* and sheet *D* having a shrinkage-suppressing effect disposed on the opposite sides of the multilayer structure of the substrate green sheets as the result of the firing were removed by means of wet blasting (produced by Macoho Co., Ltd.) using alumina abrasives #2000 and an air pressure of 0.17 MPa to 0.2 MPa.

As a result, a ceramic substrate provided on the surfaces thereof with columnar sintered metal conductors having a height of around 55 µm was obtained. The fired ceramic substrate as a whole exhibited no shrinkage in the plane direction thereof and great shrinkage only in the thickness direction thereof. The degree of shrinkage after the firing was in the approximate range of +0.2% to +0.4%.

A resin sheet each having a thickness of 60 µm were disposed respectively on the surfaces of the ceramic substrate having the sintered metal conductors formed thereon and laminated therewith in the same manner as in Example 1. The laminating conditions were the same as in Example 1. The vacuum laminator was then used to cure the resin material. The curing conditions were the same as in Example 1.

The cured resin surface of the substrate was ground by means of a grinder (produced by DISCO Corporation) at a peripheral wheel speed of 1 µm/sec to grind the resin layer by 20 µm and expose the upper surfaces of the sintered metal conductors to the resin layer surface. Consequently, the composite wiring board of Example 8 was obtained.

An evaluation was made with respect to Examples 1 to 8, in each of which since the columnar sintered metal conductors formed on the surface of the ceramic substrate were pierced through the resin layers to exposed the upper surfaces thereof to the resin layers, it was confirmed that the conductors could be utilised as connection vias, heat radiation vias, etc.

It was also confirmed from the results of the observation of the surfaces of the fired ceramic substrates that the amount of the residuals (sintered products of the conductor formation sheets) on the fired ceramic substrate and conductors was reduced to a great extent in Examples 3 to 8 using as the conductor formation sheets the sheets containing calcium carbonate as compared with Examples 1 and 2 only using the shrinkage suppression green sheets as the conductor formation sheets. In each of Examples 4 to 8 performing the firing in the state wherein the shrinkage suppression sheet was disposed on the outside of the sheet containing calcium carbonate (conductor formation sheet), the fired conductor formation sheet rapidly self-exfoliated from the ceramic substrate during the course of cooling. In Example 3 merely using the sheet containing calcium carbonate as the conductor formation sheet, the conductor formation sheet did not exfoliate immediately after the firing, but was decomposed into pieces in the atmosphere several hours after the firing.

Incidentally, the height of the sintered metal conductors in Examples 4 and 5 in which the firing was performed in the state in which the shrinkage suppression sheet was disposed on the outside of the sheet containing calcium carbonate (conductor formation sheet) was increased by 5 µm in comparison with that in Examples 1 and 3. This is because the conductive paste filled in the conductor formation sheet projected from the outermost layer (shrinkage suppression green sheet) during the course of the pressure application in the case where the shrinkage suppression green sheet was disposed on the conductor formation sheet. The amount of the projection varies depending on the degree of density of the conductive paste and the degree of shrinkage of the shrinkage suppression green sheet pressurised.

It was found that from the comparison in degree of shrinkage of the fired substrate among Examples 3 to 6 where the sheet containing calcium carbonate was used for the conductor formation sheet that the substrate could be more reliably prevented from being shrunk by the binding force sufficiently exerted on the substrate when the shrinkage compression green sheet was disposed on the outside of the sheet containing calcium carbonate (conductor formation sheet). Furthermore, it was confirmed that the number of the sintered metal conductors being deteriorated in each of Examples 7 and 8 was reduced in comparison with that of each of Examples 4 to 6.

## Claims

1. A method for manufacturing a composite wiring board, comprising the steps of :-
- forming a through hole in a sheet having a shrinkage-suppressing effect and filling the through hole with conductive paste (18) to obtain a sheet (15, 16) for formation of a conductor;
- firing the sheet for formation of the conductor and a green sheet (11 a, 11 b, 11 c, 11 d, 11 e) for a substrate in their laminated state to obtain a ceramic substrate having a surface provided with a sintered metal conductor (6);
- removing from the surface of the ceramic substrate a fired product of the sheet having the shrinkage-suppressing effect; and
- forming a resin layer on the surface of the ceramic substrate, **characterised in that** the step of firing is performed in a state wherein the sheet (15, 16, 61, 71, 81, 82) for formation of the conductor is further laminated with a sheet (83) having a shrinkage-suppressing effect.

2. A method for manufacturing a composite wiring board according to claim 1, wherein the sheet having the shrinkage-suppressing effect is a green sheet (17) for shrinkage suppression.

3. A method for manufacturing a composite wiring board according to claim 2, wherein the green sheet (17) for shrinkage suppression contains a sintering aid and at least one member selected from the group consisting of quartz, cristobalite and tridymite and that the sintering aid is at least one species selected from the group consisting of oxides softened or forming a liquid phase at a temperature equal to or less than a sintering starting temperature of the green sheet for the substrate and alkali metal compounds.

4. A method for manufacturing a composite wiring board according to claim 2, wherein the green sheet (17) for shrinkage suppression contains tridymite sintered in the step of firing and an oxide not sintered in the step of firing.

5. A method for manufacturing a composite wiring board according to claim 1, wherein the sheet having the shrinkage-suppressing effect is a sheet containing calcium carbonate.

6. A method for manufacturing a composite wiring board according to claim 1, wherein the sheet (83) having a shrinkage-suppressing effect is a sheet containing zirconium oxide or aluminum oxide.

7. A method for manufacturing a composite wiring board according to any one of the preceding claims and further comprising the step of laminate printing conductive paste (64a, 64b) on a surface of the sheet (63) having the shrinkage-suppressing effect.

8. A method for manufacturing a composite wiring board according to any one of claims 1 to 6 and further comprising the steps of forming a concavity in the sheet (63) having the shrinkage-suppressing effect, filling the concavity with conductive paste (64a, 64b) and laminating the sheet (71) for formation of the conductor and the green sheet (11) for the substrate so that the conductive paste in the concavity is in contact with the green sheet for the substrate.

9. A method for manufacturing a composite wiring board according to any one of the preceding claims, wherein the green sheet (11) for the substrate comprises a plurality of green sheets (11 a, 11 b, 11c, 11 d, 11e) laminated into a laminate and wherein the sheet (15, 16, 61, 71, 81, 82) for formation of the conductor is disposed on at least one surface of the laminate.

10. A method for manufacturing a composite wiring board according to any one of the preceding claims, wherein the step of forming the resin layer (2, 3) comprises disposing a resin sheet (31) on the surface of the ceramic substrate and laminating it thereon by means of vacuum lamination.

11. A method for manufacturing a composite wiring board according to claim 10, wherein the vacuum lamination comprises disposing the ceramic substrate (1) and resin sheet (31) between a heating flat plate (42) and a film (43), depressurising spacing defined by the heating flat plate and film and using heated air to swell the film and urge the ceramic substrate and resin sheet toward the heating flat plate, thereby completing the lamination.

12. A method for manufacturing a composite wiring board according to claim 10 and further comprising the step of curing the resin sheet (31) laminated on the ceramic substrate using a heating atmosphere as a medium.

13. A method for manufacturing a composite wiring board according to claim 12, wherein the step of curing the resin sheet (31) comprises pressure application using the heating atmosphere as the medium.

14. A method for manufacturing a composite wiring board according to claim 10, wherein the resin sheet is a resin material formed on a support and brought to a semi-hardened state.

15. A method for manufacturing a composite wiring board according to any one of claims 10 to 14, wherein when the ceramic substrate (1) has an area s (mm²) and a thickness of t (mm), s/t is in a range of 10,000 to 250,000.

16. A method for manufacturing a composite wiring board according to any one of the preceding claims and further comprising the step of grinding a surface of the resin layer (2, 3) formed on the surface of the ceramic substrate (1).

## Patentansprüche

1. Ein Verfahren zur Herstellung einer Verbundleiterplatte, das die folgenden Schritte beinhaltet:
- Bilden eines Durchgangslochs in einer Schicht, die einen Schrumpfungsunterdrückungseffekt aufweist, und Füllen des Durchgangslochs mit Leiterpaste (18), um eine Schicht (15, 16) zur Bildung eines Leiters zu erhalten;
- Brennen der Schicht zur Bildung des Leiters und einer grünen Schicht (11a, 11 b, 11 c, 11 d, 11 e) für ein Substrat in deren laminiertem Zustand, um ein Keramiksubstrat, das eine Oberfläche aufweist, die mit einem Sintermetallleiter (6) versehen ist, zu erhalten;
- Entfernen eines gebrannten Produkts der Schicht, die den Schrumpfungsunterdrückungseffekt aufweist, von der Oberfläche des Keramiksubstrats; und
- Bilden eines Harzbelags auf der Oberfläche des Keramiksubstrats, **dadurch gekennzeichnet, dass** der Schritt des Brennens in einem Zustand durchgeführt wird, in dem die Schicht (15, 16, 61, 71, 81, 82) zur Bildung des Leiters mit einer Schicht (83), die einen Schrumpfungsunterdrückungseffekt aufweist, weiter laminiert wird.

2. Verfahren zur Herstellung einer Verbundleiterplatte gemäß Anspruch 1, wobei die Schicht, die den Schrumpfungsunterdrückungseffekt aufweist, eine grüne Schicht (17) zur Schrumpfungsunterdrückung ist.

3. Verfahren zur Herstellung einer Verbundleiterplatte gemäß Anspruch 2, wobei die grüne Schicht (17) zur Schrumpfungsunterdrückung ein Sinterhilfsmittel und mindestens ein Element, ausgewählt aus der Gruppe, bestehend aus Quarz, Cristobalit und Tridymit, enthält, und das Sinterhilfsmittel mindestens eine Spezies ist, ausgewählt aus der Gruppe, bestehend aus Oxiden, die erweicht sind oder bei einer Temperatur, die gleich oder niedriger ist als eine Sinterstarttemperatur der grünen Schicht für das Substrat, eine Flüssigphase bilden, und Alkalimetallverbindungen.

4. Verfahren zur Herstellung einer Verbundleiterplatte gemäß Anspruch 2, wobei die grüne Schicht (17) zur Schrumpfungsunterdrückung im Brennschritt gesinterten Tridymit und ein im Brennschritt nicht gesintertes Oxid enthält.

5. Verfahren zur Herstellung einer Verbundleiterplatte gemäß Anspruch 1, wobei die Schicht, die den Schrumpfungsunterdrückungseffekt aufweist, eine Schicht ist, die Calciumcarbonat enthält.

6. Verfahren zur Herstellung einer Verbundleiterplatte gemäß Anspruch 1, wobei die Schicht (83), die einen Schrumpfungsunterdrückungseffekt aufweist, eine Schicht ist, die Zirconiumoxid oder Aluminiumoxid enthält.

7. Verfahren zur Herstellung einer Verbundleiterplatte gemäß einem der vorhergehenden Ansprüche und das ferner den Schritt des Laminatdruckens der Leiterpaste (64a, 64b) auf eine Oberfläche der Schicht (63), die einen Schrumpfungsunterdrückungseffekt aufweist, beinhaltet.

8. Verfahren zur Herstellung einer Verbundleiterplatte gemäß einem der Ansprüche 1 bis 6, und das ferner die Schritte des Bildens einer Höhlung in der Schicht (63), die den Schrumpfungsunterdrückungseffekt aufweist, des Füllens der Höhlung mit Leiterpaste (64a, 64b) und des Laminierens der Schicht (71) zur Bildung des Leiters und der grünen Schicht (11) für das Substrat beinhaltet, so dass die Leiterpaste in der Höhlung mit der grünen Schicht für das Substrat in Kontakt ist.

9. Verfahren zur Herstellung einer Verbundleiterplatte gemäß einem der vorhergehenden Ansprüche, wobei die grüne Schicht (11) für das Substrat eine Vielzahl grüner Schichten (11a, 11b, 11c, 11d, 11e), die zu einem Laminat laminiert sind, beinhaltet, und wobei die Schicht (15, 16, 61, 71, 81, 82) zur Bildung des Leiters auf mindestens einer Oberfläche des Laminats angeordnet ist.

10. Verfahren zur Herstellung einer Verbundleiterplatte gemäß einem der vorhergehenden Ansprüche, wobei der Schritt des Bildens des Harzbelags (2, 3) das Anordnen einer Harzschicht (31) auf der Oberfläche des Keramiksubstrats und das Laminieren derselben darauf mittels Vakuumlaminierung beinhaltet.

11. Verfahren zur Herstellung einer Verbundleiterplatte gemäß Anspruch 10, wobei die Vakuumlaminierung das Anordnen des Keramiksubstrats (1) und der Harzschicht (31) zwischen einer flachen Heizplatte (42) und einem Film (43), das Verringern des Drucks im Zwischenraum, der durch die flache Heizplatte und den Film definiert ist, und das Verwenden erhitzter Luft, um den Film aufzublähen und das Keramiksubstrat und die Harzschicht in Richtung der flachen Heizplatte zu treiben, wodurch die Laminierung abgeschlossen wird, beinhaltet.

12. Verfahren zur Herstellung einer Verbundleiterplatte gemäß Anspruch 10, und das ferner den Schritt des Aushärtens der Harzschicht (31), die auf das Keramiksubstrat laminiert ist, unter Verwendung einer Heizatmosphäre als ein Medium beinhaltet.

13. Verfahren zur Herstellung einer Verbundleiterplatte gemäß Anspruch 12, wobei der Schritt des Aushärtens der Harzschicht (31) Druckausübung unter Verwendung der Heizatmosphäre als ein Medium beinhaltet.

14. Verfahren zur Herstellung einer Verbundleiterplatte gemäß Anspruch 10, wobei die Harzschicht ein Harzmaterial ist, das auf einem Träger gebildet und in einen halbgehärteten Zustand gebracht wird.

15. Verfahren zur Herstellung einer Verbundleiterplatte gemäß einem der Ansprüche 10 bis 14, wobei, wenn das Keramiksubstrat (1) eine Fläche s (mm²) und eine Dicke von t (mm) aufweist, s/t in einem Bereich von 10 000 bis 250 000 liegt.

16. Verfahren zur Herstellung einer Verbundleiterplatte gemäß einem der vorhergehenden Ansprüche, und das ferner den Schritt des Schleifens einer Oberfläche des Harzbelags (2, 3), der auf der Oberfläche des Keramiksubstrats (1) gebildet wurde, beinhaltet.

## Revendications

1. Une méthode de fabrication d'une carte imprimée composite, comprenant les étapes consistant à :
- former un trou débouchant dans une feuille présentant un effet de suppression de retrait et remplir le trou débouchant avec une pâte conductrice (18) afin d'obtenir une feuille (15, 16) destinée à la formation d'un conducteur ;
- cuire la feuille destinée à la formation du conducteur et une feuille de céramique crue (11 a, 11 b, 11 c, 11 d, 11 e) destinée à former un substrat dans leur état stratifié afin d'obtenir un substrat céramique présentant une surface pourvue d'un conducteur en métal fritté (6) ;
- retirer de la surface du substrat céramique un produit cuit de la feuille présentant l'effet de suppression de retrait ; et
- former une couche de résine sur la surface du substrat céramique, **caractérisée en ce que** l'étape de cuisson est effectuée dans un état dans lequel la feuille (15, 16, 61, 71, 81, 82) destinée à la formation du conducteur est en outre stratifiée avec une feuille (83) présentant un effet de suppression de retrait.

2. Une méthode de fabrication d'une carte imprimée composite selon la revendication 1, dans laquelle la feuille présentant l'effet de suppression de retrait est une feuille de céramique crue (17) destinée à la suppression de retrait.

3. Une méthode de fabrication d'une carte imprimée composite selon la revendication 2, dans laquelle la feuille de céramique crue (17) destinée à la suppression de retrait contient une aide au frittage et au moins un élément sélectionné dans le groupe constitué de quartz, cristobalite et tridymite, et l'aide au frittage est au moins une espèce sélectionnée dans le groupe constitué d'oxydes adoucis ou formant une phase liquide à une température inférieure ou égale à une température de début de frittage de la feuille de céramique crue pour le substrat et de composés de métaux alcalins.

4. Une méthode de fabrication d'une carte imprimée composite selon la revendication 2, dans laquelle la feuille de céramique crue (17) destinée à la suppression de retrait contient de la tridymite frittée dans l'étape de cuisson un oxyde non fritté dans l'étape de cuisson.

5. Une méthode de fabrication d'une carte imprimée composite selon la revendication 1, dans laquelle la feuille présentant l'effet de suppression de retrait est une feuille contenant du carbonate de calcium.

6. Une méthode de fabrication d'une carte imprimée composite selon la revendication 1, dans laquelle la feuille (83) présentant un effet de suppression de retrait est une feuille contenant de l'oxyde de zirconium ou de l'oxyde d'aluminium.

7. Une méthode de fabrication d'une carte imprimée composite selon une quelconque des revendications précédentes et comprenant en outre l'étape consistant à imprimer en stratifié une pâte conductrice (64a, 64b) sur une surface de la feuille (63) présentant l'effet de suppression de retrait.

8. Une méthode de fabrication d'une carte imprimée composite selon une quelconque des revendications 1 à 6 et comprenant en outre les étapes consistant à former une concavité dans la feuille (63) présentant l'effet de suppression de retrait, à remplir la concavité avec une pâte conductrice (64a, 64b) et à stratifier la feuille (71) destinée à la formation du conducteur et la feuille de céramique crue (11) destinée au substrat de sorte que la pâte conductrice dans la concavité soit en contact avec la feuille de céramique crue destinée au substrat.

9. Une méthode de fabrication d'une carte imprimée composite selon une quelconque des revendications précédentes, dans laquelle la feuille de céramique crue (11) destinée au substrat comprend une pluralité de feuilles de céramique crue (11a, 11 b, 11 c, 11d, 11e) stratifiées en un stratifié et dans laquelle la feuille (15, 16, 61, 71, 81, 82) destinée à la formation du conducteur est disposée sur au moins une surface du stratifié.

10. Une méthode de fabrication d'une carte imprimée composite selon une quelconque des revendications précédentes, dans laquelle l'étape consistant à former la couche de résine (2, 3) comprend les opérations consistant à disposer une feuille de résine (31) sur la surface du substrat céramique et à la stratifier sur celle-ci au moyen d'une stratification sous vide.

11. Une méthode de fabrication d'une carte imprimée composite selon la revendication 10, dans laquelle la stratification sous vide comprend les opérations consistant à disposer le substrat céramique (1) et la feuille de résine (31) entre une plaque plate chauffante (42) et un film (43), à dépressuriser un espacement défini par la plaque plate chauffante et le film et à utiliser de l'air chauffé pour faire gonfler le film et pousser le substrat céramique et la feuille de résine vers la plaque plate chauffante, terminant ainsi la stratification.

12. Une méthode de fabrication d'une carte imprimée composite selon la revendication 10 et comprenant en outre l'étape consistant à faire durcir la feuille de résine (31) stratifiée sur le substrat céramique en utilisant une atmosphère chauffante comme milieu.

13. Une méthode de fabrication d'une carte imprimée composite selon la revendication 12, dans laquelle l'étape consistant à faire durcir la feuille de résine (31) comprend une application de pression en utilisant l'atmosphère chauffante comme milieu.

14. Une méthode de fabrication d'une carte imprimée composite selon la revendication 10, dans laquelle la feuille de résine est un matériau de résine formé sur un support et amené à un état semi-durci.

15. Une méthode de fabrication d'une carte imprimée composite selon une quelconque des revendications 10 à 14, dans laquelle lorsque le substrat céramique (1) présente une superficie s (mm²) et une épaisseur de t (mm), la valeur de s/t est comprise entre 10 000 et 250 000.

16. Une méthode de fabrication d'une carte imprimée composite selon une quelconque des revendications précédentes et comprenant en outre l'étape consistant à meuler une surface de la couche de résine (2, 3) formée sur la surface du substrat céramique (1).
